# FASCICULE DE BREVET EUROPEEN

(11) **EP 3 000 137 B1**
(45) Date de publication et mention de la délivrance du brevet: **10.04.2019**
(21) Numéro de dépôt: 14729409.4
(22) Date de dépôt: 12.05.2014
(51) Int. Cl.: H01L 33/58, H01L 31/054, H01L 31/18, H01L 31/0216, H01L 31/0232

(54) **PROCÉDÉ DE FABRICATION D'UN DISPOSITIF PHOTOSENSIBLE**
VERFAHREN ZUR HERSTELLUNG EINER LICHTEMPFINDLICHEN VORRICHTUNG
METHOD FOR PRODUCING A PHOTOSENSITIVE DEVICE

(30) Priorité: 22.05.2013 FR 1354618
(43) Date de publication de la demande: 30.03.2016
(73) Titulaire: Electricité de France, 75008 Paris (FR); Centre National de la Recherche Scientifique - CNRS, 75794 Paris Cedex 16 (FR)
(72) Inventeur: PAIRE, Myriam, 75017 Paris (FR); GUILLEMOLES, Jean-François, 75013 Paris (FR); LOMBEZ, Laurent, 92000 Nanterre (FR); LINCOT, Daniel, 92160 Antony (FR); COLLIN, Stéphane, 94230 Cachan (FR); PELOUARD, Jean-Luc, 75020 Paris (FR)
(74) Mandataire: Cabinet Plasseraud
(86) Numéro de dépôt international: PCT/FR2014/051093
(87) Numéro de publication internationale: WO 2014/188105

(56) Documents cités:
- WO-A1-2012/096239
- US-A1- 2008 272 450
- US-A1- 2012 138 121
- US-A1- 2013 122 633

## Description

### DOMAINE TECHNIQUE

L'invention se rapporte au domaine des dispositifs optoélectroniques équipés de systèmes de concentration de la lumière.

### ARRIÈRE-PLAN TECHNOLOGIQUE

Les technologies employant des dispositifs optoélectroniques comme les photodétecteurs, les diodes électroluminescentes (communément appelées LED) ou les dispositifs photovoltaïques peuvent bénéficier d'une réduction de la quantité de matière utilisée pour réaliser les portions photoactives en employant des systèmes de concentration de la lumière.

En effet, les dispositifs employant des systèmes de concentration de la lumière requièrent moins de matière semi-conductrice pour produire une puissance électrique donnée ou pour éclairer un espace donné par rapport aux dispositifs dépourvus de tels systèmes. Dans le cas de cellules photovoltaïques, l'utilisation de systèmes à concentration de lumière permet d'utiliser à moindre coût des matériaux absorbeurs de lumière à haut rendement de conversion.

L'alignement des systèmes optiques de concentration de la lumière sur les dispositifs photosensibles est un procédé difficile à réaliser. Classiquement, cet alignement fait intervenir des procédés imageants, comme le contrôle par caméra, qui sont des procédés coûteux.

De manière générale, l'alignement des optiques sur des cellules photosensibles se fait cellule par cellule. Ce procédé séquentiel d'alignement fait intervenir des robots de précision qui servent souvent également à positionner les cellules sur le substrat hôte. Cette technique présente le désavantage d'être à la fois coûteuse et d'autant plus longue à mettre en oeuvre qu'il y a de lentilles et donc de cellules.

Certains fabricants proposent une étape préalable de photolithographie pour faciliter l'alignement des optiques dites secondaires, en contact avec les cellules photosensibles, sur ces cellules. Les optiques secondaires sont généralement des lentilles, posées sur les cellules photosensibles, et utilisées en combinaison avec des lentilles dites primaires, de grande taille. Ces dernières sont situées au-dessus des cellules, à une distance correspondant sensiblement à leur distance focale. Ce procédé présente le désavantage de nécessiter malgré tout un alignement intrinsèque pour définir les motifs de lithographie aux endroits appropriés, en tenant compte de la géométrie des cellules photosensibles. Un autre exemple d'alignement des systèmes de concentration de la lumière sur des dispositifs photosensibles est décrit dans le document US 2012/085276 A1.

Il existe donc un besoin de mettre au point un procédé permettant de simplifier l'étape d'alignement des systèmes de concentration de la lumière sur des dispositifs photosensibles.

### EXPOSE DE L'INVENTION

Pour y parvenir, la présente invention propose un procédé selon la revendication 1 permettant l'auto-alignement d'un système de concentration de la lumière au-dessus de cellules photosensibles.

L'invention propose plus particulièrement un procédé de fabrication d'un dispositif photosensible comprenant :
- une première étape de préparation sur un substrat, d'au moins une première portion photosensible. Cette première portion photosensible est active dans une gamme déterminée de longueurs d'onde. Une deuxième portion, inactive et électriquement isolante, entoure la première portion photosensible.

Par la suite, un matériau, recouvrant une surface supérieure opposée au substrat de la première portion, est sélectivement agencé en une couche hydrophile à l'aplomb de la première portion active par un procédé électrochimique, tandis que la deuxième portion comporte, sur une surface supérieure opposée au substrat, un matériau hydrophobe. Le procédé comporte par ailleurs les étapes suivantes :
- l'aspersion, sur l'ensemble des surfaces supérieures des première et deuxième portions, d'une solution liquide comportant un matériau transparent dans la gamme de longueurs d'onde dans laquelle la première portion est active, et
- la formation d'une lentille convergente comportant le matériau transparent au-dessus de la première portion.

Ce procédé consiste donc dans un premier temps à recouvrir la surface supérieure d'une portion photosensible avec un matériau hydrophile, tandis que la portion inactive qui l'entoure possède une surface supérieure hydrophobe. Ce contraste entre surface hydrophile et surface hydrophobe, réparties sélectivement entre la première portion active et la deuxième portion inactive, permet à la solution liquide déposée dans un deuxième temps de former une goutte préférentiellement au-dessus de la surface hydrophile, et donc au-dessus de la portion photosensible. Le terme aspersion est à comprendre dans un sens large, et peut inclure une pluralité de méthodes d'application d'une solution liquide, comme par exemple le trempage, la pulvérisation, ou l'enduction centrifuge. La goutte ainsi constituée forme un système de concentration de la lumière, en particulier une lentille convergente. L'alignement du système optique sur la portion photosensible est donc immédiat. Ce procédé permet ainsi de ne plus avoir recourt à des dispositifs d'alignement coûteux et des dispositifs déposant les lentilles une par une.

Un autre avantage de ce procédé est que la structuration en surface hydrophile et hydrophobe peut ne nécessiter aucune étape d'alignement ou de gravure. En effet, la surface supérieure de la première portion peut être sélectivement rendue plus ou moins hydrophile. Il est entendu par « sélectivement » rendue plus ou moins hydrophile qu'aucun masque n'est utilisé lors de la mise en oeuvre du procédé électrochimique permettant d'obtenir une couche hydrophile à l'aplomb de la première portion active. Le caractère sélectif de l'obtention d'une telle couche hydrophile est possible grâce aux propriétés de conducteur électrique de la première portion active, par opposition à la deuxième portion, électriquement isolante.

Différents procédés électrochimiques peuvent être envisagés pour agencer le matériau recouvrant la première portion en une couche hydrophile. Ainsi, une telle couche hydrophile peut être obtenue par un électro-dépôt, s'effectuant sélectivement sur les premières portions actives du fait de la nature électriquement conductrice de ces premières portions. En guise d'alternative, il est aussi possible de déposer un matériau initialement hydrophobe recouvrant à la fois les première et deuxième portions, et d'effectuer un traitement par application d'une tension à la première portion active. Ce traitement rend le matériau hydrophile sélectivement à l'aplomb des premières portions actives uniquement.

Avantageusement, le matériau hydrophile est déposé sélectivement sur la surface supérieure opposée au substrat de la première portion active. Un dépôt présente l'avantage de permettre un positionnement sélectif au-dessus des première ou deuxième portions. Par exemple, lorsque la première portion active est un conducteur électrique, le matériau hydrophile peut être électro-déposé sélectivement sur la surface supérieure opposée au substrat de la première portion active.

Il est aussi possible que la surface supérieure opposée au substrat de la première portion soit rendue hydrophile après traitement. En effet, il est avantageux de pouvoir ajuster les propriétés hydrophiles d'un matériau déposé sur la première portion active de manière à distinguer son hydrophilie de celle de la deuxième portion inactive. Alternativement, cette possibilité de modifier les propriétés hydrophiles du matériau déposé permet d'envisager un mode de réalisation dans lequel les surfaces supérieures de la première et de la deuxième portions sont recouvertes d'un même matériau, et dans lequel un traitement, par exemple électrique, permet de rendre sélectivement hydrophile uniquement les zones situées à l'aplomb de la première portion active.

Le terme hydrophile se rapporte ici à une aptitude à former un film de liquide en surface, possédant un angle de contact inférieur, par exemple, à 90°. Cette propriété n'est pas limitative à un type de liquide en particulier. De même le terme hydrophobe se rapporte ici à une aptitude à former un film de liquide en surface, possédant un angle de contact supérieur, par exemple, à 90°.

Le procédé comprend avantageusement le dépôt d'un matériau à propriétés hydrophiles sur la surface supérieure opposée au substrat dans la première portion.

Les propriétés hydrophiles du matériau déposé sont à interpréter comme ayant une signification large, à savoir que le matériau déposé peut être intrinsèquement hydrophile, ou bien qu'il peut être rendu hydrophile moyennant un traitement. De même, il est possible d'ajuster l'hydrophilie du matériau déposé.

Selon un autre mode de réalisation, la surface supérieure opposée au substrat de la première portion peut être rendue hydrophile après traitement.

Par exemple, il est possible de déposer un même matériau sur la surface supérieure de la première et de la seconde portions, puis de procéder à un traitement électrochimique pour rendre le matériau sélectivement hydrophile uniquement à l'aplomb de la première portion active.

Dans la pratique, plusieurs matériaux peuvent être utilisés pour recouvrir la surface supérieure de la première portion photosensible.

Il est notamment avantageux d'utiliser un oxyde à grand gap, comme le ZnO, le ZnO dopé ou le TiO₂. Ces matériaux sont particulièrement adaptés au procédé objet de l'invention étant donné l'existence de procédés rapides et peu coûteux permettant un dépôt sélectif de ces oxydes sur des portions photosensibles. Le brevet FR 2934611 divulgue par exemple un procédé d'électro-dépôt de ZnO sélectivement sur les surfaces supérieures d'absorbeurs de cellules photovoltaïques, ces absorbeurs étant électriquement conducteurs sous éclairement. Il est alors avantageux d'avoir une deuxième portion inactive dont la surface supérieure est un isolant électrique.

Les oxydes à grand gap sont avantageusement soumis à une étape de traitement par exposition à un rayonnement ultra-violet préalablement à l'aspersion d'une solution liquide sur leur surface supérieure. En exposant ainsi la surface supérieure de la première portion active, recouverte d'un oxyde à grand gap, l'hydrophilie de la surface supérieure de l'oxyde à grand gap augmente. Cette étape permet donc de préparer la surface supérieure à recevoir une solution liquide formant des gouttes sur le matériau hydrophile. Il est à noter que ce traitement par exposition à un rayonnement ultra-violet ne nécessite pas non plus l'emploi d'un masque. L'hydrophilie des surfaces hydrophobes, entourant le matériau hydrophile, n'est pas affectée par l'exposition à un rayonnement ultra-violet.

Cette étape de traitement de la surface supérieure de la première portion active préalablement à l'étape d'aspersion d'une solution liquide peut aussi être faite via l'application d'un potentiel électrique, et donc par le passage d'un courant électrique. Un tel traitement comprenant l'application d'un potentiel électrique augmente sélectivement l'hydrophilie d'un matériau à l'aplomb de la première portion active. Ce traitement exploite la propriété du matériau recouvrant la première portion active d'être au moins partiellement électriquement conducteur.

Ces deux traitements électromagnétiques permettent donc d'augmenter sélectivement l'hydrophilie du matériau à l'aplomb des premières portions actives.

Alternativement, il est possible de recourir au dépôt, sur la surface supérieure de la première portion active, d'au moins une couche antireflets. Cette couche antireflets peut être composée d'un empilement de plusieurs couches, pouvant être des oxydes. L'utilisation d'une couche ou d'une pluralité de couches antireflets permet de réduire la proportion de lumière incidente réfléchie sur le système de concentration de la lumière, et donc d'augmenter la quantité de lumière reçue par la première portion active. Cette couche ou cette pluralité de couches sont agencées de manière à pouvoir se déposer sélectivement sur la surface supérieure de la première portion active, et de manière à posséder une surface supérieure exposée qui soit hydrophile.

La solution liquide déposée sur les surfaces supérieures exposées, à l'aplomb de la première portion et de la deuxième portion, peut être choisie parmi une pluralité de solutions liquides.

De manière avantageuse, la solution liquide comporte un matériau durcissant, par exemple un monomère.

Il peut par exemple s'agir d'une résine photosensible, transparente dans le visible, et ayant un indice optique élevé. Des exemples de telles résines photosensibles sont la résine SU8 ou la résine AZ®40XT. Une étape de durcissement de la solution liquide pour former une lentille convergente au-dessus de la première portion est possible. Il peut s'agir d'un durcissement par des traitements thermiques ou par l'exposition de la surface supérieure de la première portion, contenant une goutte de solution liquide, à un rayonnement ultra-violet. Cette étape intervient après l'étape d'aspersion d'une solution liquide sur les surfaces supérieures exposées de la première et deuxième portion. Ce durcissement permet de figer la forme de la lentille au-dessus de la première portion et d'assurer un contact permanent entre la lentille et la surface supérieure hydrophile au-dessus de la première portion active. L'étape de durcissement peut par ailleurs offrir un degré de liberté supplémentaire dans la définition de la forme de la lentille, certains procédés de durcissement étant de nature à affecter cette forme. Tel est par exemple le cas d'un recuit thermique.

La première portion photosensible peut nécessiter la présence de contacts électriques. Ces contacts peuvent par exemple être déposés entre la première étape de formation, sur le substrat, de la deuxième et première portions, et l'étape d'aspersion. Ces contacts se présentent généralement sous la forme d'une couche métallique hydrophile en contact avec la première portion. Le dépôt des contacts métalliques peut se faire également pendant la première étape de formation des première et deuxième portions.

L'avantage supplémentaire conféré par la présence de ces contacts électriques hydrophiles est qu'ils permettent d'étendre la surface de la goutte formée après l'étape d'aspersion au-dessus de la première portion photosensible. Il est en effet envisageable d'utiliser les contacts électriques pour augmenter la taille de la lentille formée au-dessus de la première portion. La quantité de lumière collectée par le dispositif de concentration de la lumière issu du procédé peut alors être suffisante pour utiliser la lentille formée en optique principale. Ainsi, le procédé de fabrication d'un panneau comprenant de telles cellules photosensibles s'en trouve simplifié.

Plusieurs applications sont envisagées pour le procédé objet de l'invention.

Il peut concerner plus particulièrement des cellules photovoltaïques, auquel cas la première portion active est un absorbeur de lumière de cellule photosensible.

La deuxième portion inactive, est un isolant électrique. Les isolants électriques de type films polymères présentent l'avantage d'avoir des surfaces hydrophobes. D'autres matériaux comme les céramiques de terre rare ou oxydes de terre rare peuvent également être envisagés en guise d'isolants électriques hydrophobes.

Une fois que la lentille est formée au-dessus de la cellule photosensible, il est possible de l'épaissir par le dépôt d'un revêtement en un matériau transparent dans la gamme de longueurs d'onde dans laquelle la cellule photosensible est active.

Ce revêtement agit comme un espaceur, qui permet d'augmenter la surface collectrice de lumière. L'espaceur augmente aussi la distance entre la surface supérieure de la lentille et la cellule photosensible à l'aplomb de laquelle la lentille est située. Cela permet notamment d'optimiser la position du point de focalisation de la lentille sur la cellule photosensible.

Le procédé peut aussi s'utiliser à une échelle industrielle, pour fabriquer des dispositifs de concentration de la lumière comprenant plusieurs portions actives. La première étape comprend alors la préparation, sur un substrat, d'un réseau de premières portions, actives dans une gamme de longueurs d'onde, et séparées les unes des autres par une deuxième portion inactive.

La réalisation d'un réseau de portions actives peut se faire à l'aide de procédés économes en matière première. Notamment, il est avantageux d'effectuer, lors de la première étape, un dépôt sélectif des premières portions sur un substrat comprenant la deuxième portion. Alternativement, il est également possible de déposer d'abord les premières portions actives sur le substrat, puis la ou les deuxièmes portions.

Le procédé objet de l'invention permet de réaliser des dispositifs optoélectroniques à concentration de la lumière dans lesquels les lentilles sont alignées au-dessus des zones photosensibles avec une meilleure précision que dans les dispositifs obtenus par les techniques connues de l'Homme du métier.

Ainsi, l'invention propose également un dispositif photosensible selon la revendication 17 comprenant sur un substrat :
- au moins une première portion photosensible, active dans une gamme de longueurs d'onde,
- une seconde portion inactive et électriquement isolante, entourant la première portion.

Le dispositif photosensible présente la particularité que la première portion comporte un matériau sélectivement agencé en une couche hydrophile à l'aplomb de la première portion active par un procédé électrochimique sur une surface supérieure opposée au substrat, tandis que la surface supérieure opposée au substrat de la seconde portion comporte un matériau hydrophobe.

Par ailleurs, une lentille convergente formée sur la surface supérieure du matériau hydrophile possède un axe optique perpendiculaire au substrat aligné avec le centre géométrique de la première portion. Le décalage entre cet axe optique et le centre géométrique de la première portion peut être inférieur à un nanomètre.

Ce faible décalage entre l'axe optique de la lentille et le centre géométrique de la première portion photosensible peut être plus faible que le décalage garanti par les techniques d'alignement faisant intervenir des caméras et des robots de précision. En effet, les robots de précision peuvent positionner les lentilles avec un pas d'environ 100 nm. Le procédé objet de l'invention peut permettre un alignement d'une lentille sur une portion photosensible avec un décalage entre l'axe optique de la lentille et le centre géométrique de la portion photosensible inférieur au nanomètre. Le dispositif résultant du procédé peut donc être particulièrement efficace lorsque les dimensions de la lentille sont réduites, par exemple de taille micrométrique.

Le dispositif issu du procédé décrit ci-avant présente une qualité optique particulièrement avantageuse pour des lentilles sensiblement circulaires de diamètre inférieur à 100 µm. En effet, à partir d'une telle taille de lentille, un désalignement de l'axe optique de la lentille par rapport au centre géométrique de la portion photosensible peut donner lieu à des aberrations de nature à réduire la qualité de la concentration de la lumière sur la portion photosensible.

### DESCRIPTIF DES FIGURES

D'autres avantages et caractéristiques de l'invention apparaîtront à la lecture de la description détaillée ci-après d'exemples de réalisations présentés à titre illustratif, aucunement limitatifs, et en référence aux dessins annexés sur lesquels :
- la figure 1 illustre un exemple de dispositif pouvant être issu du procédé objet de l'invention;
- les figures 2a, 2b et 2c illustrent des étapes d'un procédé de fabrication d'une portion photosensible active munie d'une lentille et entourée d'une portion inactive selon un premier mode de réalisation de l'invention;
- la figure 3 illustre un dispositif issu du procédé objet de l'invention selon un second mode de réalisation;
- les figures 4a, 4b et 4c illustrent des étapes d'un procédé de fabrication d'une portion photosensible active munie d'une lentille et entourée d'une portion inactive selon un troisième mode de réalisation de l'invention;
- les figures 5a et 5b illustrent des étapes d'un procédé de fabrication d'une portion photosensible active munie d'une lentille et entourée d'une portion inactive selon un quatrième mode de réalisation de l'invention ;
- les figures 6a et 6b illustrent des étapes d'un procédé de fabrication d'une portion photosensible active munie d'une lentille et entourée d'une portion inactive selon un cinquième mode de réalisation de l'invention.
- la figure 7 illustre les étapes d'un procédé de fabrication d'une portion photosensible active munie d'une lentille et entourée d'une portion inactive selon un sixième mode de réalisation de l'invention.

Pour des raisons de clarté, les dimensions des différents éléments représentés sur ces figures ne sont pas nécessairement en proportion avec leurs dimensions réelles. Sur les figures, des références identiques correspondent à des éléments identiques.

### DESCRIPTION DÉTAILLÉE

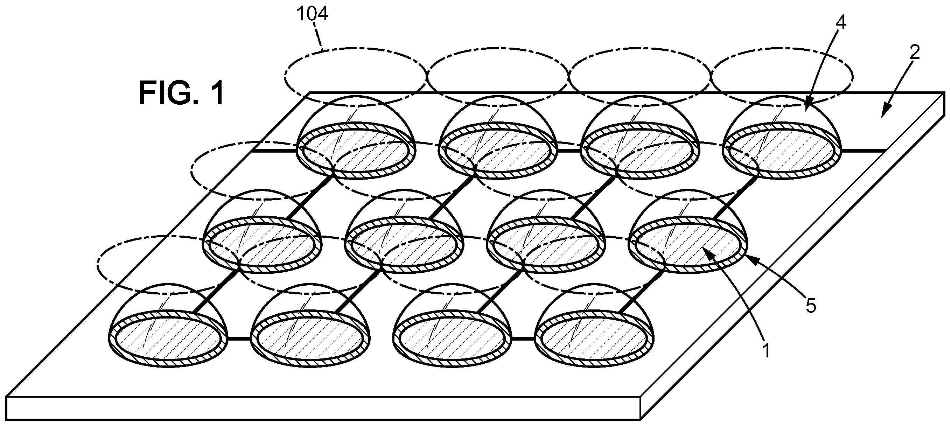

Comme illustré sur la figure 1, l'objet de la présente invention concerne principalement la fabrication de systèmes photosensibles à concentration de lumière. Ces systèmes peuvent par exemple être des réseaux de dispositifs tels des cellules photovoltaïques 1, reliées électriquement par des contacts métalliques 5. Les cellules photovoltaïques sont prévues pour être de petite taille, ce qui permet de diminuer leurs coûts de production et envisager l'emploi de matériaux à haut rendement énergétique. Ces cellules photosensibles 1 sont munies sur leurs surfaces supérieures de lentilles 4, formant des optiques secondaires. Au-dessus de ces lentilles, des optiques dites primaires 104 permettent de focaliser la lumière sur les lentilles 4. Ces optiques primaires permettent de collecter une portion plus importante de lumière grâce à leur surface élargie, et de focaliser cette lumière sur les cellules photovoltaïques 1. Les optiques secondaires 4, situées sous les optiques primaires 104, permettent d'augmenter l'angle d'acceptance du système à deux niveaux de lentilles, c'est-à-dire que les cellules photovoltaïques 1 peuvent collecter plus de lumière arrivant en incidence non normale sur les optiques primaires 104. Ainsi, plus de lumière est collectée grâce aux lentilles primaires 104, et le système collecte également plus de lumière non perpendiculaire au premier plan de lentilles 104 à l'aide des optiques secondaires 4. Le procédé objet de l'invention permet de faciliter grandement l'alignement des optiques secondaires, les lentilles 4, sur les cellules photosensibles 1.

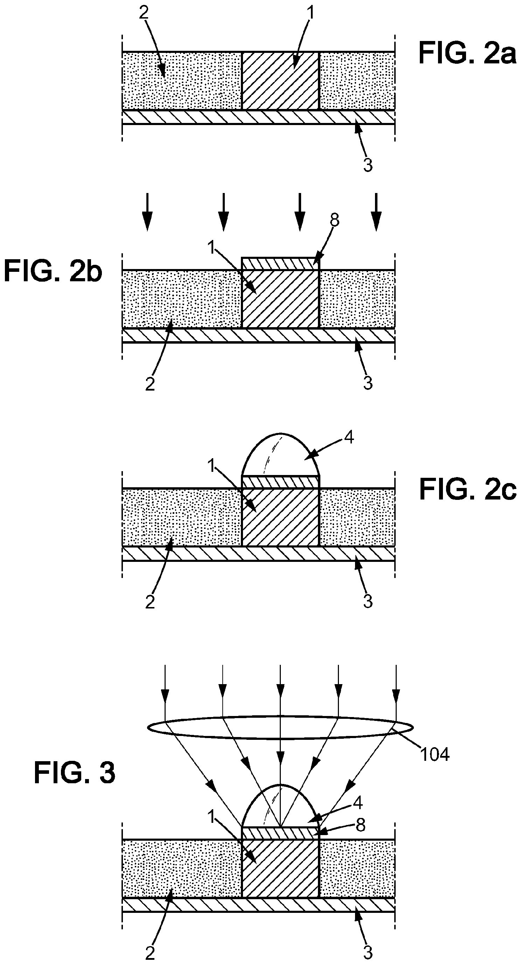

On se réfère tout d'abord aux figures 2a, 2b et 2c sur lesquelles sont illustrées des étapes d'un procédé de fabrication d'un dispositif optoélectronique, avantageusement un dispositif photosensible. Ce procédé consiste en premier lieu à fabriquer sur un substrat 3 une première portion 1 entourée d'une deuxième portion 2, comme indiqué sur la figure 2a. La première portion 1 est active dans une gamme de longueurs d'onde déterminée. Le terme « active » signifie que la première portion 1 manifeste une photosensibilité ou un spectre en émission remarquable. Par exemple, cette photosensibilité ou ce spectre en émission remarquable peut se présenter sous la forme d'un pic d'absorption ou d'un pic en émission. Les techniques utilisées pour réaliser ces première 1 et deuxième 2 portions peuvent être des procédés dits bottom-up connus de l'Homme du métier, comme par exemple l'électro-dépôt, l'impression ou la co-évaporation à travers un masque. La surface des première 1 et deuxième 2 portions en contact avec le substrat est appelée par la suite surface inférieure. Concomitamment, la surface opposée à cette surface inférieure est appelée surface supérieure.

Comme indiqué sur la figure 2b, la surface supérieure de la première portion 1 est munie d'une couche 8 en un matériau hydrophile. Cette couche 8 est déposée sélectivement sur la face supérieure de la première portion 1, sans atteindre la deuxième portion 2.

Le terme hydrophile est employé ici pour désigner une aptitude à former des surfaces de mouillage importantes. Plus particulièrement, il sera considéré par la suite qu'un matériau est hydrophile lorsque le dépôt d'un liquide sur sa surface supérieure s'accompagne de la formation d'une goutte liquide possédant un angle de contact inférieur, par exemple, à 90°. L'angle de contact est défini comme étant l'angle entre la surface et la tangente à la goutte liquide à l'interface air/liquide/solide. Le terme hydrophile ne limite pas la caractéristique liée à la surface de mouillage à un type de liquide particulier, et peut aussi bien servir à caractériser des matériaux destinés à recevoir des solutions aqueuses, des huiles ou tout autre liquide visqueux.

L'emploi du terme hydrophobe sert ici à caractériser des matériaux qui possèdent une aptitude à former des surfaces de mouillage moindres que les matériaux dits hydrophiles auxquels il sera fait référence. En particulier, un matériau sera considéré comme hydrophobe lorsque l'angle de contact du film de liquide déposé sur sa surface supérieure est supérieur par exemple à 90°.

La couche 8 en un matériau hydrophile peut également être complétée par un empilement de plusieurs couches, dont la surface supérieure exposée possède des propriétés hydrophiles. Ce mode de réalisation particulier peut par exemple concerner le cas d'un revêtement antireflet comprenant une pluralité de couches de matériaux d'indices optiques différents. Dans le cas particulier où le procédé consiste à fabriquer des cellules photovoltaïques ou des photodétecteurs, il convient de réaliser les connexions électriques de la première portion 1 active avant le dépôt de cet empilement de couches. En effet, les couches antireflets sont souvent constituées en surface d'une fine couche d'un matériau électriquement isolant. Il est également possible que la couche 8 ait des propriétés antireflets sans nécessiter le dépôt d'une ou d'une pluralité de couches supplémentaires.

Il convient d'observer que la forme de la première portion 1 n'est pas nécessairement circulaire. Il est possible de fabriquer une première portion 1 de forme allongée, ou rectangulaire par exemple. La couche 8 hydrophile déposée en surface de cette première portion 1 épouse avantageusement la géométrie de cette première portion 1.

La couche 8 peut avantageusement être réalisée en un matériau choisi parmi les oxydes à grand gap. Ces matériaux sont connus pour leur hydrophilie sous illumination UV. Plus particulièrement, l'oxyde de zinc (ZnO), éventuellement l'oxyde de zinc dopé ou encore l'oxyde de titane (TiO₂) et l'oxyde de titane dopé étain (ITO) sont des matériaux envisagés car ils peuvent présenter notamment l'avantage d'être faciles à déposer. Le brevet FR 2934611 décrit un procédé d'électro-dépôt de ZnO sur des cellules Cu(In,Ga)Se₂. Il est donc particulièrement avantageux d'utiliser les enseignements de ce brevet pour effectuer un dépôt d'oxyde à grand gap comme le ZnO sur la première portion 1 se présentant alors sous la forme de cellule photovoltaïque. L'électro-dépôt du ZnO sur la première portion 1 se fait de manière sélective et auto-alignée, du fait du caractère électriquement conducteur de l'absorbeur d'une cellule photovoltaïque sous éclairement. De nombreuses techniques sont connues de l'homme de métier pour changer la rugosité de ces oxydes, ce qui peut moduler leur hydrophilie. Entre autres, des gravures en solution acide, comme des solutions aqueuses d'acide chlorhydrique, permettent de rugosifier ces oxydes en surface.

Afin de bénéficier du dépôt sélectif d'un oxyde à grand gap comme le ZnO sur une première portion 1 active grâce aux enseignements du brevet FR 2934611, il est particulièrement avantageux d'utiliser une deuxième portion 2 inactive qui soit un isolant électrique.

Lorsque le choix du matériau constitutif de la couche 8 se porte sur un oxyde à grand gap comme le ZnO, il est avantageux de prévoir une étape d'illumination sous rayonnement ultra-violet de la surface supérieure de cette couche 8. Une telle étape permet d'accroître l'hydrophilie de la surface supérieure de la couche 8. L'accroissement de l'hydrophilie correspond ici à une diminution de l'angle de contact d'une goutte de liquide déposée sur la surface supérieure de la couche 8.

De manière avantageuse, le choix du matériau utilisé pour constituer la couche 8 prend en compte les propriétés optiques de cette couche. Il est particulièrement avantageux que la couche 8 soit transparente dans la même gamme de longueurs d'onde que la gamme de longueurs d'onde dans laquelle la première portion 1 est active.

L'ensemble des surfaces supérieures du dispositif réalisé aux étapes décrites ci-avant présente les particularités suivantes : la surface exposée située à l'aplomb de la première portion 1, active dans une gamme de longueurs d'ondes, est hydrophile, tandis que la surface exposée située à l'aplomb de la deuxième portion 2 inactive est hydrophobe.

Le caractère hydrophobe de la surface exposée à l'aplomb de la deuxième portion 2 inactive peut être une propriété intrinsèque du matériau utilisé pour fabriquer la deuxième portion 2 inactive. Par exemple, dans une application particulière où la première portion 1 est une cellule photovoltaïque, la deuxième portion 2 inactive est avantageusement un isolant électrique, possédant naturellement des propriétés hydrophobes. Il peut par exemple être choisi parmi des matériaux résistant en température ou des polymères.

Les films polymères hydrophobes isolants peuvent être choisis parmi les résines photosensibles comme la résine SU8, ou des composés dérivés du tetrafluoroéthylène. Il pourra aussi être particulièrement intéressant de disposer de matériaux adaptés aux fortes températures pouvant être atteintes lors de recuits pendant la fabrication de la première portion 1. Ces matériaux hydrophobes, isolants électriques et résistants en température, peuvent être choisis parmi les céramiques de terres rares, ou les matériaux utilisés pour réaliser des joints d'étanchéité comme le Therma Pur®. Parmi les céramiques de terre rares, certaines peuvent être déposées par des procédés couches minces comme CeO₂ ou Er₂O₃.

Par ailleurs, il est envisageable de procéder à une étape supplémentaire de dépôt, avant la fabrication de la première portion 1 active, d'une couche de matériau possédant des propriétés hydrophobes sur la surface supérieure de la deuxième portion 2 inactive. Ce cas est avantageux dans le mode de réalisation employant des céramiques de terre rares. Il est également envisageable d'utiliser un empilement de couches hydrophobes, par exemple un isolant inorganique classique et une fine couche de céramiques de terre rares, afin de déposer moins de céramiques. Il est aussi envisageable de rendre la surface de la deuxième portion 2 hydrophobe par greffage de molécules après le dépôt de la portion photosensible 1 et de son recuit, et avant le dépôt de la couche 8 en ZnO. Ainsi, les polymères par exemple de type octadecyltrichlorosilane (OTS) ou perfluorodecyltrichlorosilane (PFTS) se greffent préférentiellement sur la silice, qui peut servir d'isolant électrique pour constituer la deuxième portion 2, sans se greffer sur les contacts métalliques 5 ou le ZnO.

Comme suggéré par la figure 2c, le procédé comprend une étape d'application, sur l'ensemble des surfaces supérieures du dispositif réalisé aux étapes précédentes, d'une solution liquide. Cette solution liquide peut par exemple être de l'eau, une solution contenant des monomères, ou une solution contenant des polymères. Le dépôt de cette solution liquide peut avantageusement se faire par aspersion, ou bien encore par pulvérisation, trempage ou enduction centrifuge.

Le contraste en hydrophilie entre la surface supérieure de la couche 8 et la surface supérieure de la deuxième portion 2 inactive impose une répartition particulière de la solution liquide sur l'ensemble des surfaces supérieures exposées du dispositif réalisé aux étapes précédentes. Ainsi, la solution liquide n'adhère pas à la surface hydrophobe et tend à s'écouler sans y former de gouttes, tandis qu'elle est retenue sous forme de goutte sur la surface supérieure de la couche 8. En fonction des propriétés de la surface supérieure de la couche 8, des propriétés de la solution liquide et de l'environnement ambiant, l'angle de contact de la goutte sur la surface supérieure de la couche 8 peut varier. Il est donc possible de choisir des solutions liquides, des conditions de dépôt et de structurer la surface supérieure de la couche 8 de manière particulière afin d'obtenir une goutte de forme recherchée. Le rayon de courbure des lentilles formées est aussi un paramètre ajustable du procédé permettant en particulier d'adapter la distance focale de la lentille. Par exemple, suivant la quantité de matière apportée lors de l'application de la solution liquide, la goutte peut prendre la forme d'un dôme ou d'une portion de sphère.

Dans certaines applications, une forme particulière peut également être conférée à la goutte formée sur la surface supérieure de la couche 8 par l'application d'un champ électrique.

Avantageusement, la solution liquide est choisie de manière à posséder des propriétés optiques compatibles avec la gamme de longueurs d'onde dans laquelle la première portion 1 est active. Elle est donc avantageusement transparente dans cette gamme de longueurs d'onde.

Parmi les substances que la solution liquide peut contenir, il est possible d'inclure une résine photosensible comme la résine SU8, qui se polymérise sous l'action des rayonnements ultra-violets et est transparente dans le visible.

Afin de figer la forme de la goutte présente à la surface supérieure de la couche 8, il est possible de procéder à une étape de traitement thermique, comme par exemple un chauffage, ou bien, par exemple dans le cas de résines photosensibles, à une illumination sous un rayonnement permettant de solidifier la résine. Dans le cas de la résine SU8, il s'agit d'un rayonnement ultra-violet.

Alternativement, selon un mode particulier de réalisation, il est possible de ne pas faire subir à la goutte déposée au-dessus de la première portion 1 une transition liquide-solide.

Les techniques connues de l'Homme du métier pour contrôler la forme et les propriétés optiques des lentilles 4 ainsi formées peuvent être appliquées. Il est ainsi possible d'adapter la composition du monomère ou polymère contenu dans la solution liquide pour modifier la viscosité de cette dernière. Il est également possible d'effectuer plusieurs trempages successifs pour épaissir la lentille 4.

Afin d'optimiser davantage la concentration de lumière sur la première portion 1 active, il est possible d'utiliser, en combinaison avec le dispositif décrit ci-avant muni d'une lentille auto-alignée sur un dispositif optoélectronique, un second système de concentration de la lumière 104 situé à l'aplomb de ladite lentille 4, comme représenté sur la figure 3. L'alignement de ce second système de concentration, pouvant par exemple être une lentille de focale plus grande, fait appel à des techniques d'alignement connues de l'Homme du métier. Ce second système de concentration 104 permet de collecter une plus grande portion de lumière incidente. En effet, le gain en matière première utilisée pour constituer la première portion 1 active s'accompagne d'une diminution de la surface supérieure de ladite première portion 1 exposée au rayonnement incident. Il est donc avantageux de prévoir ce second système de concentration 104 pour compenser ce défaut.

Un procédé alternatif de structuration en surface hydrophile à l'aplomb de la première portion 1 active est envisagé. Ce procédé consiste à déposer un oxyde grand gap de type ZnO sur la première 1 et deuxième 2 portions. Le dépôt peut se faire par pulvérisation, ou par dépôt chimique en phase vapeur, entre autres. Après ou pendant le dépôt du ZnO, le substrat est trempé par exemple dans une solution d'acide gras, de façon à rendre toute la surface hydrophobe. Un exemple de tel acide gras est l'acide stéarique. La création d'une zone hydrophile peut se faire alors à l'aide du caractère électriquement conducteur de la première portion 1 et du caractère électriquement isolant de la deuxième portion 2. En effet, en se plaçant dans un électrolyte, par exemple une solution de K₂SO₄ diluée, et en passant un courant anodique à travers la première portion 1, pouvant alors être polarisée en direct, on peut modifier la surface du ZnO à l'aplomb de la première portion 1, et détruire l'acide gras présent en surface grâce au passage d'un courant d'oxydation. On crée alors de façon auto-alignée une zone hydrophile à l'aplomb de la première portion 1, le ZnO à l'aplomb de la deuxième portion 2 restant hydrophobe.

Le procédé ainsi décrit peut s'appliquer à des dispositifs optoélectroniques de différente nature. Il est par exemple envisageable que la première portion 1 soit un semiconducteur émetteur de lumière, comme une LED, possédant des connexions électriques fournissant un courant à cette première portion 1. Le procédé convient tout particulièrement aux LED pouvant être composées d'un oxyde à grand gap en surface, comme par exemple les diodes à base d'InGaN. La fabrication d'une lentille, à l'aide du procédé décrit ci-avant, ne nécessite aucune étape d'alignement de ladite lentille sur la diode électroluminescente. La lentille permet de répartir la lumière émise par la LED sur un angle solide qui dépend des propriétés optiques de la lentille.

Une autre application particulièrement avantageuse concerne les dispositifs photosensibles, comme les photodétecteurs ou les cellules photovoltaïques. L'utilisation du procédé décrit ci-avant permet de réduire la surface de la première portion 1, réduisant les coûts de production, et de bénéficier de rendements énergétiques élevés à l'aide du système de concentration de la lumière agencé à l'aplomb de cette première portion 1. L'invention dispense l'utilisateur d'une étape coûteuse d'alignement des systèmes de concentration de la lumière sur la première portion 1 active.

Dans le cas particulier où la première portion 1 est une cellule photovoltaïque, la première portion 1 peut avantageusement être un absorbeur de lumière. Ce dernier peut par exemple être fabriqué en un alliage Cu(In,Ga)Se₂, utilisé dans les microcellules en couches minces. D'autres matériaux, avantageusement les matériaux formant un absorbeur de lumière apte à recevoir un dépôt localisé d'oxyde en surface comme le CdTe, le CZTS, le silicium amorphe, ou le silicium monocristallin sont compatibles avec ce procédé.

Le mode de réalisation particulier dans lequel la première portion 1 est un absorbeur de lumière de cellule photovoltaïque présente un avantage supplémentaire. Il permet d'envisager, pour des applications associées à des microcellules en couches minces, de supprimer l'étape de dépôt, au-dessus de l'absorbeur de lumière, des couches dites tampon, de CdS ou ZnS. Ces couches tampon sont généralement fabriquées par dépôt en bain chimique qui est un procédé non sélectif qui revient à déposer une couche de CdS sur tout le substrat. Il est également possible de conserver les couches tampons de CdS ou ZnS et de les déposer sélectivement par électro-dépôt, de manière à conserver le caractère hydrophobe des zones situées en dehors des cellules photovoltaïques.

En évitant le dépôt de ces couches tampon ou en procédant à des dépôts localisés, l'utilisateur parvient à un gain en coût de production et conserve la nature chimique naturellement hydrophobe des zones situées en dehors des cellules photovoltaïques, c'est-à-dire la deuxième portion 2 inactive.

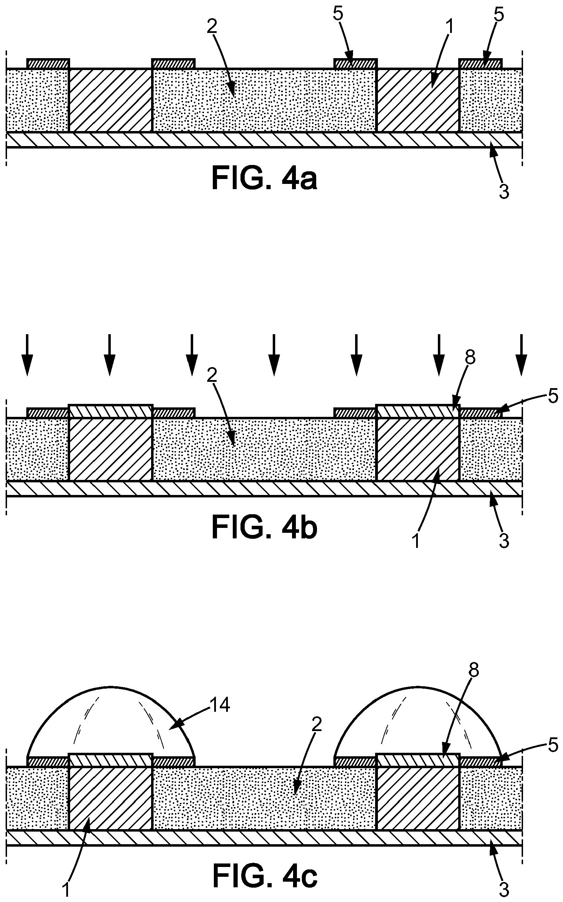

Toujours en relation avec une première portion 1 formant un absorbeur de lumière pour une application en photovoltaïque, la périphérie de la première portion 1 comprend, sur une partie de la surface supérieure de la deuxième portion 2, un contact électrique métallique 5, comme représenté sur la figure 4a. Ces contacts électriques 5 périphériques sont couramment employés dans les systèmes photovoltaïques à concentration de la lumière pour limiter les pertes résistives. Ces contacts métalliques 5 sont donc avantageusement reliés à un dispositif de collection du courant électrique. Il est alors possible d'exploiter les propriétés naturellement hydrophiles de ces contacts métalliques pour étendre la surface sur laquelle les gouttes de solution liquide s'étendent lors de l'étape d'aspersion de la solution liquide sur les surfaces supérieures de la couche hydrophile 8 et de la deuxième portion 2. Les étapes associées à ce procédé sont représentées sur les figures 4a, 4b et 4c.

Les contacts métalliques 5 peuvent être traités sélectivement pour ajuster leur hydrophilie, par exemple avec des polymères. Ce traitement ou fonctionnalisation du métal 5 peut être effectué par trempage dans des solutions chimiques sélectives, par exemple de type thiol. Ce trempage peut accroître l'hydrophilie du métal 5 ou bien au contraire le rendre hydrophobe. La différentiation entre la couche hydrophile 8 et le métal peut alors se faire par leur différence de comportement électrochimique. Le contact métallique est donc un degré de liberté pour définir la zone hydrophile.

Le dépôt des contacts métalliques 5 peut intervenir à différentes étapes du procédé. Selon un mode de réalisation privilégié, il intervient par dépôt sur la deuxième portion 2, avant la formation d'évidements dans cette deuxième portion 2, destinés à accueillir les premières portions actives 1. Alternativement, les contacts métalliques 5 peuvent être déposés après la formation des premières portions 1 et avant le dépôt de la couche 8 en matériau hydrophile. Dans ce mode de réalisation, un contact électrique effectif est établi entre le métal 5 et la première portion 1 active au moment du dépôt de la couche 8 en ZnO.

De manière à protéger les contacts métalliques 5 du recuit thermique à des températures pouvant être comprises entre 500°C et 600°C intervenant lors de la réalisation de la première portion 1, il est possible de recouvrir les contacts métalliques 5 d'une fine couche par exemple d'oxyde ou de carbure.

Comme suggéré par la figure 4c, il est possible d'utiliser le contact métallique périphérique 5 pour ajuster sensiblement la taille de la lentille formée au-dessus de l'absorbeur de cellule photovoltaïque.

La configuration représentée sur la figure 4c ne comprend pas de couche d'espacement sous la lentille formée au-dessus de l'absorbeur de la cellule photovoltaïque. La lumière collectée par la lentille est concentrée grâce au pouvoir de focalisation de la lentille 14 dont la surface a une aire supérieure à celle de la surface de la première portion 1 active. Ceci présente l'avantage de permettre la collecte par la lentille 14 d'une plus grande quantité de lumière, dont une majeure partie est focalisée sur la première portion 1 active. Par ailleurs, la zone métallique périphérique 5 peut se comporter comme un miroir réverbérant les rayonnements, qui peuvent alors partiellement être réfléchis dans la lentille et être focalisés sur l'absorbeur 1. Ceci permet notamment de limiter les pertes optiques dans les zones ne comprenant pas d'absorbeur 1.

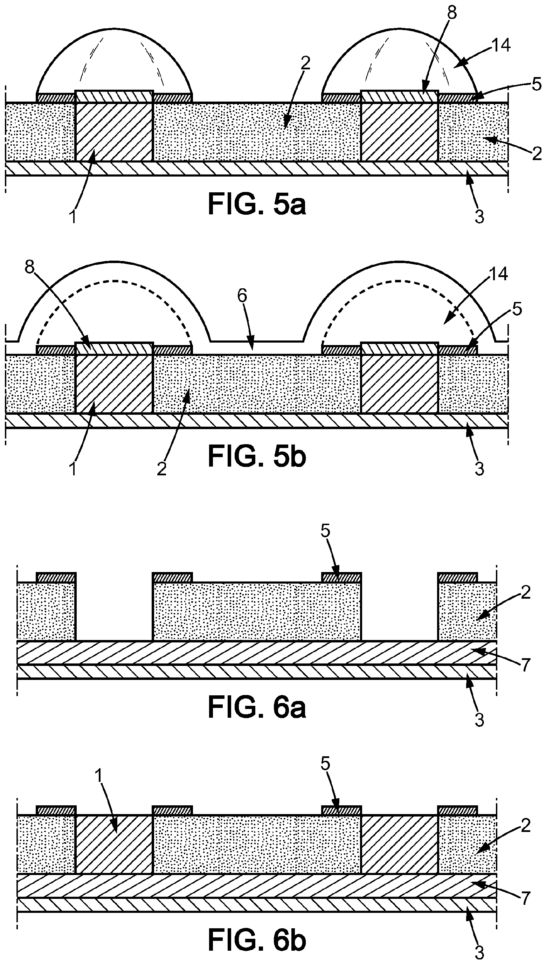

Comme représenté sur les figures 5a et 5b, il est possible d'ajouter, après l'étape de formation des systèmes de concentration de lumière 14, une étape supplémentaire visant à créer un espaceur 6. Le terme espaceur est employé afin de désigner un éloignement perpendiculairement au substrat, entre le système de concentration de lumière 14, et la première portion 1 active. Cet espaceur 6 est avantageusement réalisé par le dépôt d'un revêtement recouvrant de manière homogène et avec une épaisseur constante la lentille 14 et la deuxième portion 2 inactive. Avantageusement, cet espaceur 6 est composé d'un matériau possédant sensiblement le même indice optique que la lentille 14. L'espaceur 6 confère deux avantages : il permet d'une part d'épaissir le système de concentration de lumière 14, en agrandissant la surface exposée au rayonnement incident, et d'autre part, il éloigne la lentille 14 de la première portion 1 active. Il est ainsi possible de concentrer une quantité sensiblement plus importante de lumière sur la première portion 1 active, augmentant le rendement optique du système. Il sera néanmoins avantageux de limiter l'épaisseur de cet espaceur 6, car pour de grandes épaisseurs, le profil des microlentilles 14 ne serait pas conservé.

Un autre avantage associé à l'utilisation du procédé pour la fabrication d'une cellule photovoltaïque en couches minces est qu'il permet d'envisager une étape supplémentaire lors de la fabrication des première 1 et deuxième 2 portions. En effet, il est envisagé dans un premier temps de structurer le substrat, tel que représenté sur les figures 6a et 6b, uniquement grâce à la présence de la deuxième portion 2 inactive. Cette deuxième portion 2 est généralement formée d'un isolant électrique. La première portion 1 est réalisée grâce à un dépôt sélectif par électro-dépôt ou par dépôt d'encre. Ce mode de réalisation permet d'économiser davantage de matière première nécessaire à la fabrication des absorbeurs de lumière.

En déposant la deuxième portion 2 avant la première portion 1, il est également possible d'améliorer la qualité du dépôt de la première portion 1. En effet, l'électro-dépôt de la première portion 1 se fait alors naturellement en dehors de la deuxième portion 2, dans l'espace destiné à recevoir la première portion 1. Dans le cas d'un procédé de dépôt à base d'encre, le caractère hydrophobe de la deuxième portion 2 et le dénivelé présenté par cette portion favorisent le dépôt sélectif de l'encre dans l'espace destiné à accueillir la première portion 1.

Naturellement, lorsque les cellules photovoltaïques sont des cellules en couches minces, il est avantageux de prévoir une couche conductrice 7 formant un contact arrière, réalisée sur la face supérieure du substrat. Cette couche est traditionnellement une couche en molybdène dans le cas des cellules à base de cuivre, indium, gallium et sélénium, appelées cellules CIGS. Lorsque la couche 7 est continue, les cellules photovoltaïques sont reliées en parallèle. Le contact arrière 7 peut éventuellement ne pas être continu, permettant ainsi de relier les cellules en série.

Bien que le procédé qui a été décrit ci-avant se rapporte à au moins une première portion 1 active entourée d'une deuxième portion 2 inactive, elle peut avantageusement se rapporter à un réseau de premières portions 1 actives, par exemple un réseau de photodétecteurs, de LED ou de cellules photovoltaïques, chaque première portion 1 active étant entourée d'une deuxième portion 2 inactive.

Le dispositif issu du procédé décrit ci-avant présente une qualité d'alignement des systèmes à concentration de la lumière sur les cellules photosensibles supérieure à celle obtenue par les techniques d'alignement mettant en oeuvre des caméras et des robots de précision. En effet, grâce au procédé décrit ci-avant, il n'y a pas de défauts de positionnement lors de l'alignement des lentilles sur les cellules photovoltaïques.

### Exemple de réalisation

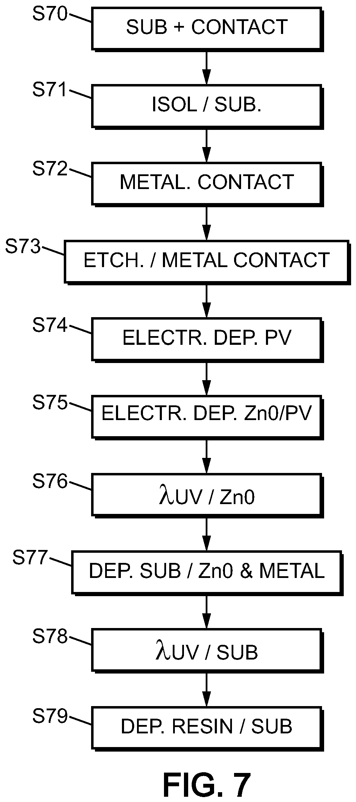

Comme représenté schématiquement en dix étapes à la figure 7, il est tout d'abord proposé de fabriquer un substrat 3 comprenant une couche formant contact arrière 7. Cette première étape S70 est suivie par le dépôt sur ledit substrat 3 d'une couche d'isolant 2 à l'étape S71. Sur ce substrat 3 muni d'une couche de matériau isolant 2, comme par exemple une résine SU8, des contacts métalliques 5 sont déposés, à l'étape S72. Des emplacements sont ensuite gravés dans les contacts métalliques 5 à l'étape S73, s'étendant jusqu'à la couche formant contact arrière 7.

L'étape suivante S74, consiste à déposer sélectivement, par électro-dépôt ou impression par encre, l'absorbeur 1 de cellules photovoltaïques, comme par exemple un alliage de type Cu(In,Ga)Se₂. Ce dépôt est suivi d'un recuit, à une température pouvant être comprise entre 500°C et 600°C pour cristalliser le matériau. À l'étape notée S75, il est procédé à un électro-dépôt d'oxyde à grand gap comme le ZnO sur le dispositif obtenu aux étapes précédentes. Le ZnO se dépose sélectivement sur les absorbeurs 1 de cellules photovoltaïques, qui sont électriquement conducteurs par opposition aux isolants électriques 2 qui entourent ces derniers. Il est souhaitable que la couche 8 de ZnO soit en contact avec le métal des contacts métalliques 5 entourant l'absorbeur 1 des cellules photovoltaïques, ce contact étant déterminé par les conditions de dépôt de la couche 8. Pour être conducteur, le ZnO est avantageusement dopé.

Cette étape est suivie de l'étape S76 d'illumination sous rayonnement ultra-violet des surfaces supérieures de ZnO. Cette exposition à un rayonnement ultra-violet augmente l'hydrophilie du ZnO.

Il est ensuite procédé, à l'étape S77, à un dépôt par aspersion d'une résine SU8 sur les surfaces supérieures de ZnO et d'isolant électrique 2. Ceci conduit à la formation de gouttes sur les surfaces supérieures de ZnO qui se répartissent également sur le dessus des contacts métalliques 5 périphériques, également hydrophiles, tandis que la résine SU8 s'écoule sur la surface supérieure de l'isolant électrique.

Par la suite, une exposition de ladite résine à un rayonnement ultraviolet à l'étape notée S78, provoque un durcissement des gouttes situées sur l'ensemble formé par le ZnO 8 et les contacts métalliques 5, formant ainsi des lentilles 14 solides au-dessus des cellules photovoltaïques.

Finalement, il est prévu de procéder au dépôt d'une résine possédant un indice optique sensiblement identique à celui des lentilles 14. Cette étape, notée S79, comprend aussi le durcissement de cette résine, qui forme ainsi un espaceur 6 remplissant la double fonction d'épaississant pour les lentilles et de couche permettant un éloignement entre la surface extérieure des lentilles et les cellules photovoltaïques.

### Exemple de réalisation n°2

Il est tout d'abord proposé de fabriquer un substrat 3 comprenant une couche formant un contact arrière 7. Cette première étape est suivie par le dépôt sur ledit substrat 3 d'une couche d'isolant 2. Sur ce substrat 3 muni d'une couche de matériau isolant 2, comme par exemple un polymère, de l'alumine ou de la silice, on grave ensuite des emplacements s'étendant jusqu'à la couche formant le contact arrière 7.

L'étape suivante consiste à déposer sélectivement, par électro-dépôt ou impression par encre, l'absorbeur de cellules photovoltaïques 1, comme par exemple un alliage de type Cu(In,Ga)Se₂. Ce dépôt est suivi d'un recuit. À l'étape suivante il est procédé à un dépôt d'oxyde à grand gap 8 comme le ZnO sur le dispositif obtenu aux étapes précédentes. Ce dépôt n'est pas nécessairement sélectif, et peut être réalisé par pulvérisation, ou dépôt chimique en phase vapeur. Un traitement de surface peut être alors réalisé pour s'assurer du caractère hydrophobe de la couche 8 d'oxyde grand gap. Par exemple de l'acide stéarique, ou du téflon peuvent être déposés en surface.

Cette étape est suivie d'une étape d'électrochimie pour laquelle le substrat 3 est plongé dans un électrolyte et un potentiel est appliqué entre les zones conductrices, à savoir les premières portions 1 photosensibles, et l'électrolyte. Un courant passe alors par ces premières portions 1, ce qui modifie l'état de surface du ZnO. Ainsi le ZnO à l'aplomb des premières portions 1 acquiert un caractère hydrophile, soit par désorption du dépôt hydrophobe de surface, soit par oxydation de ce dépôt, soit encore par changement de l'état de surface du ZnO, s'il n'a pas été procédé à un dépôt de matière hydrophobe. Ce changement de caractère hydrophobe/hydrophile se fait de manière auto-alignée sur les dispositifs en raison du caractère conducteur des premières portions 1 et isolant des deuxièmes portions 2.

Il est ensuite procédé à un dépôt par aspersion d'une résine SU8 sur les surfaces supérieures de ZnO et d'isolant électrique. Ceci conduit à la formation de gouttes sur les surfaces supérieures de ZnO, tandis que la résine SU8 s'écoule sur la surface supérieure de l'isolant électrique.

Par la suite, une exposition de ladite résine à un rayonnement ultraviolet, provoque un durcissement des gouttes situées sur l'ensemble formé par le ZnO et les contacts métalliques, formant ainsi des lentilles solides au-dessus des cellules photovoltaïques.

Finalement, il est prévu de procéder au dépôt d'un contact métallique sur le ZnO à l'aplomb des deuxièmes portions 2. Ce dépôt peut se faire par voie autocatalytique, en raison du contraste chimique entre les lentilles polymères et le ZnO. Il peut aussi être envisagé par électrochimie.

L'invention ne se limite pas aux modes de réalisation décrits et comprend également des modes de réalisation équivalents.

Par exemple, il est possible d'envisager un réseau de cellules photosensibles de formes différentes, de propriétés optiques différentes et entourées de portions inactives réalisées en plusieurs matériaux différents.

Les lentilles peuvent également agir comme des filtres pour sélectionner certaines longueurs d'onde dans le spectre du rayonnement incident arrivant sur les portions actives.

Le procédé objet de l'invention peut également s'appliquer pour la formation de systèmes optiques à l'aplomb de diodes émettrices de lumière.

## Revendications

1. Procédé de fabrication d'un dispositif photosensible comprenant :
- une première étape de préparation sur un substrat (3), d'au moins une première portion photosensible (1), active dans une gamme de longueurs d'onde et possédant des propriétés de conduction électrique, ladite première portion (1) étant entourée par une deuxième portion (2), inactive et électriquement isolante,
**caractérisé en ce qu'**un matériau, recouvrant une surface supérieure opposée au substrat (3) de la première portion (1), est sélectivement agencé en une couche hydrophile à l'aplomb de la première portion active par un procédé électrochimique, tandis que la deuxième portion (2) comporte, sur une surface supérieure opposée au substrat, un matériau hydrophobe,
le procédé comportant en outre les étapes suivantes :
- aspersion sur l'ensemble desdites surfaces supérieures des première (1) et deuxième (2) portions d'une solution liquide comportant un matériau transparent dans ladite gamme de longueurs d'onde, et
- formation d'une lentille convergente (4, 14) comportant ledit matériau au-dessus de ladite première portion.

2. Procédé selon la revendication 1, **caractérisé en ce qu'**il comprend le dépôt sélectif d'un matériau à propriétés hydrophiles (8) sur la surface supérieure opposée au substrat (3) de la première portion (1).

3. Procédé selon la revendication 1 ou 2, **caractérisé en ce que** la surface supérieure opposée au substrat (3) de la première portion (1) est rendue hydrophile après traitement.

4. Procédé selon l'une des revendications précédentes, **caractérisé en ce que** le matériau hydrophile (8) est un oxyde à grand gap.

5. Procédé selon l'une quelconque des revendications précédentes, **caractérisé en ce que** le matériau hydrophile (8) est choisi parmi le groupe comprenant : ZnO, ZnO dopé, TiO₂.

6. Procédé selon l'une quelconque des revendications précédentes, **caractérisé en ce qu'**il comprend une étape de traitement de la surface supérieure de la première portion active (1) par exposition à un rayonnement ultra-violet préalablement à l'étape d'aspersion d'une solution liquide.

7. Procédé selon l'une quelconque des revendications précédentes, **caractérisé en ce qu'**il comprend un traitement de la première portion active par application d'un potentiel électrique préalablement à l'étape d'aspersion d'une solution liquide.

8. Procédé selon l'une quelconque des revendications précédentes, **caractérisé en ce que** la solution liquide comporte un matériau durcissant.

9. Procédé selon la revendication 8, **caractérisé en ce que** le matériau durcissant est un monomère.

10. Procédé selon l'une quelconque des revendications 8 ou 9, **caractérisé en ce qu'**il comprend une étape de durcissement de la solution liquide pour former une lentille convergente (4, 14) au-dessus de la première portion.

11. Procédé selon l'une quelconque des revendications 8 à 10, **caractérisé en ce que** l'étape de durcissement comprend une étape d'exposition de la surface supérieure de la première portion (1) à un rayonnement ultra-violet.

12. Procédé selon l'une quelconque des revendications précédentes, **caractérisé en ce qu'**il comprend, entre la première étape et l'étape d'aspersion, une étape de dépôt, sur une partie de la surface supérieure de la deuxième portion (2), d'une couche métallique hydrophile (5) en contact avec la première portion (1).

13. Procédé selon l'une quelconque des revendications précédentes, **caractérisé en ce que** la première portion (1), active, est un absorbeur de lumière de cellule photosensible.

14. Procédé selon l'une des quelconque des revendications précédentes, **caractérisé en ce qu'**il comprend une étape de dépôt, sur la lentille (14), d'un revêtement (6) en un matériau transparent dans la gamme de longueurs d'onde.

15. Procédé selon l'une des revendications précédentes, **caractérisé en ce que** la première étape comprend la préparation, sur un substrat (3), d'un réseau de premières portions (1), actives dans une gamme de longueurs d'onde, lesdites premières portions (1) étant séparées les unes des autres par une deuxième portion (2) inactive.

16. Procédé selon la revendication 15, **caractérisé en ce que** la première étape est un dépôt sélectif des premières portions (1) sur un substrat (3) comprenant la deuxième portion (2).

17. Dispositif photosensible comprenant sur un substrat (3)
- au moins une première portion photosensible (1), active dans une gamme de longueurs d'onde et possédant des propriétés de conduction électrique,
- une seconde portion (2) inactive où ladite première portion (1) comporte un matériau sélectivement agencé en une couche hydrophile (8) à l'aplomb de la première portion active par un procédé électrochimique sur une surface supérieure opposée au substrat, tandis que la surface supérieure opposée au substrat de ladite seconde portion (2) comporte un matériau hydrophobe, et où lentille convergente (4, 14) est formée sur la surface supérieure du matériau hydrophile (8)
**caractérisé en ce que**
la seconde portion (2) est électriquement isolante, ladite seconde portion (2) entourant ladite première portion (1).

## Patentansprüche

1. Verfahren zur Herstellung einer lichtempfindlichen Vorrichtung, aufweisend:
- einen ersten Schritt einer Herstellung mindestens eines lichtempfindlichen ersten Abschnitts (1) auf einem Substrat (3), wobei der erste Abschnitt (1) in einem Wellenlängenbereich aktiv ist und elektrische Leitfähigkeitseigenschaften aufweist und von einem inaktiven und elektrisch isolierenden zweiten Abschnitt (2) umgeben ist,
**dadurch gekennzeichnet, dass** ein Material, das eine dem Substrat (3) gegenüberliegende obere Oberfläche des ersten Abschnitts bedeckt, mit Hilfe eines elektrochemischen Verfahrens als eine hydrophile Schicht senkrecht zum aktiven ersten Abschnitt selektiv angeordnet wird, während der zweite Abschnitt (2) an einer dem Substrat gegenüberliegenden oberen Oberfläche ein hydrophobes Material aufweist,
wobei das Verfahren ferner die folgenden Schritte aufweist:
- Sprühen einer flüssigen Lösung, die ein Material aufweist, das in dem Wellenlängenbereich transparent ist, auf die Gesamtheit der Oberflächen des ersten (1) und zweiten Abschnitts (2) und
- Bilden einer Sammellinse (4, 14), die das Material aufweist, oberhalb des ersten Abschnitts.

2. Verfahren nach Anspruch 1, **dadurch gekennzeichnet, dass** es die selektive Abscheidung eines Materials (8), das hydrophile Eigenschaften hat, auf der dem Substrat (3) gegenüberliegenden oberen Oberfläche des ersten Abschnitts (1) aufweist.

3. Verfahren nach Anspruch 1 oder 2, **dadurch gekennzeichnet, dass** die dem Substrat (3) gegenüberliegende obere Oberfläche des ersten Abschnitts (1) nach Behandlung hydrophil gehalten wird.

4. Verfahren nach einem der vorstehenden Ansprüche, **dadurch gekennzeichnet, dass** das hydrophile Material (8) ein Oxid mit großer Bandlücke ist.

5. Verfahren nach einem der vorstehenden Ansprüche, **dadurch gekennzeichnet, dass** das hydrophile Material (8) aus der folgenden Gruppe ausgewählt ist: ZnO, dotiertes ZnO, TiO₂.

6. Verfahren nach einem der vorstehenden Ansprüche, **dadurch gekennzeichnet, dass** es vor dem Schritt des Sprühens einer flüssigen Lösung einen Schritt einer Behandlung der oberen Oberfläche des aktiven ersten Abschnitts (1) durch Bestrahlen mit einer Ultraviolett-Strahlung aufweist.

7. Verfahren nach einem der vorstehenden Ansprüche, **dadurch gekennzeichnet, dass** es vor dem Schritt des Sprühens einer flüssigen Lösung eine Behandlung des aktiven ersten Abschnitts durch Anwendung eines elektrischen Potentials aufweist.

8. Verfahren nach einem der vorstehenden Ansprüche, **dadurch gekennzeichnet, dass** die flüssige Lösung ein härtendes Material aufweist.

9. Verfahren nach Anspruch 8, **dadurch gekennzeichnet, dass** das härtende Material ein Monomer ist.

10. Verfahren nach einem der Ansprüche 8 oder 9, **dadurch gekennzeichnet, dass** es einen Schritt eines Härtens der flüssigen Lösung aufweist, um eine Sammellinse (4, 14) oberhalb des ersten Abschnitts zu bilden.

11. Verfahren nach einem der Ansprüche 8 bis 10, **dadurch gekennzeichnet, dass** der Härtungsschritt einen Schritt einer Bestrahlung der oberen Oberfläche des ersten Abschnitts (1) mit einer Ultraviolett-Strahlung aufweist.

12. Verfahren nach einem der vorstehenden Ansprüche, **dadurch gekennzeichnet, dass** es zwischen dem ersten Schritt und dem Sprühschritt einen Schritt einer Abscheidung einer metallischen hydrophilen Schicht (5) in Kontakt mit dem ersten Abschnitt (1) auf einem Teil der oberen Oberfläche des zweiten Abschnitts (2) aufweist.

13. Verfahren nach einem der vorstehenden Ansprüche, **dadurch gekennzeichnet, dass** der aktive erste Abschnitt (1) ein Lichtabsorbierer einer lichtempfindlichen Zelle ist.

14. Verfahren nach einem der vorstehenden Ansprüche, **dadurch gekennzeichnet, dass** es einen Schritt einer Abscheidung einer Hülle (6), die aus einem in dem Wellenlängenbereich transparenten Material besteht, auf der Linse (14) aufweist.

15. Verfahren nach einem der vorstehenden Ansprüche, **dadurch gekennzeichnet, dass** der erste Schritt die Herstellung eines Netzes von ersten Abschnitten (1), die in einem Wellenlängenbereich aktiv sind, auf einem Substrat (3) aufweist, wobei die ersten Abschnitte (1) durch einen inaktiven zweiten Abschnitt (2) voneinander getrennt sind.

16. Verfahren nach Anspruch 15, **dadurch gekennzeichnet, dass** der erste Schritt eine selektive Abscheidung der ersten Abschnitte (1) auf einem Substrat (3), das den zweiten Abschnitt (2) aufweist, ist.

17. Lichtempfindliche Vorrichtung, die auf einem Substrat (3) aufweist:
- mindestens einen lichtempfindlichen ersten Abschnitt (1), der in einem Wellenlängenbereich aktiv ist und elektrische Leitfähigkeitseigenschaften aufweist,
- einen inaktiven zweiten Abschnitt (2),
wobei der erste Abschnitt (1) ein Material aufweist, das mit Hilfe eines elektrochemischen Verfahrens als eine hydrophile Schicht (8) senkrecht zum aktiven ersten Abschnitt auf einer dem Substrat (3) gegenüberliegenden oberen Oberfläche selektiv angeordnet ist, während die dem Substrat gegenüberliegende obere Oberfläche des zweiten Abschnitts (2) ein hydrophobes Material aufweist,
und wobei eine Sammellinse (4, 14) an der oberen Oberfläche des hydrophilen Materials (8) gebildet ist,
**dadurch gekennzeichnet, dass** der zweite Abschnitt (2) elektrisch isolierend ist und den ersten Abschnitt (1) umgibt.

## Claims

1. Method for fabricating a photosensitive device, comprising:
- a first step of preparing, on a substrate (3), at least a photosensitive first portion (1) that is active within a range of wavelengths, said first portion (1) being surrounded by a second portion (2) that is inactive and electrically insulating,
**characterized in that** a material, covering an upper surface of the first portion (1) opposite the substrate (3), is selectively arranged into a hydrophilic layer directly above the first active portion by an electrochemical process, while the second portion (2) comprises a hydrophobic material on an upper surface opposite the substrate,
the method further comprising the following steps:
- spraying, over the entire upper surfaces of said first (1) and second (2) portions, a liquid solution comprising a material that is transparent within said range of wavelengths, and
- forming a converging lens (4, 14) comprising said material, over said first portion.

2. Method according to claim 1, comprising a selective deposition of a material having hydrophilic properties (8) on the upper surface opposite the substrate (3) of the first portion (1).

3. Method according to claim 1 or 2, wherein the upper surface opposite the substrate (3) of the first portion (1) is rendered hydrophilic after treatment.

4. Method according to one of the above claims, wherein the hydrophilic material (8) is a wide-bandgap oxide.

5. Method according to any of the above claims, wherein the hydrophilic material (8) is selected from among the group consisting of ZnO, doped ZnO, and TiO₂.

6. Method according to any of the above claims, comprising a treatment step of the upper surface of the first active portion (1) by exposing said upper surface to ultraviolet radiation prior to the step of spraying a liquid solution.

7. Method according to any of the above claims, comprising a treatment of the first active portion by applying an electric potential prior to the step of spraying a liquid solution.

8. Method according to any of the above claims, wherein the liquid solution comprises a hardening material.

9. Method according to claim 8, wherein the hardening material is a monomer.

10. Method according to either of claims 8 or 9, comprising a step of hardening the liquid solution to form a converging lens (4, 14) above the first portion.

11. Method according to any of claims 8 to 10, wherein the hardening step comprises a step of exposing the upper surface of the first portion (1) to ultraviolet radiation.

12. Method according to any of the above claims, comprising, between the first step and the spraying step, a step of depositing, on part of the upper surface of the second portion (2), a hydrophilic metal layer (5) in contact with the first portion (1).

13. Method according to any of the above claims, wherein the first, active, portion (1) is a light absorber of a photosensitive cell.

14. Method according to any of the above claims, comprising a step of depositing, on the lens (14), a coating (6) of a material that is transparent within the range of wavelengths.

15. Method according to any of the above claims, wherein the first step comprises the preparation, on a substrate (3), of an array of first portions (1) that are active within a range of wavelengths, said first portions (1) being separated from each other by a second inactive portion (2).

16. Method according to claim 15, wherein the first step is a selective deposition of first portions (1) on a substrate (3) comprising the second portion (2).

17. Photosensitive device comprising, on a substrate (3):
- at least a first photosensitive portion (1) which is active within a range of wavelengths,
- a second inactive portion (2)
said first portion (1) comprises a material selectively arranged into a hydrophilic layer (8) directly above the first active portion by an electrochemical process on an upper surface opposite the substrate, while the upper surface opposite the substrate of said second portion (2) comprises a hydrophobic material,
and in wherein a converging lens (4, 14) is formed on the upper surface of the hydrophilic material (8),
**characterized in that** the second portion (2) is electrically insulating, said second portion (2) surrounding the first portion (1).
